# EUROPÄISCHE PATENTANMELDUNG

(11) **EP 0 732 740 A2**
(43) Veröffentlichungstag der Anmeldung: **18.09.1996**
(21) Anmeldenummer: 96103346.1
(22) Anmeldetag: 04.03.1996
(51) Int. Cl.: H01L 23/29, H01L 23/31

(54) **Halbleiterbauelement mit Kunststoffumhüllung**

(30) Priorität: 15.03.1995 DE 19509262
(71) Anmelder: SIEMENS AKTIENGESELLSCHAFT, 80333 München (DE)
(72) Erfinder: Brunner, Herbert, 93047 Regensburg (DE)

(57) **Zusammenfassung**

Halbleiterbauelement mit einem Halbleiterkörper, der zumindest mit einem Teil seiner Oberfläche an eine Kunststoffumhüllung angrenzt. Die Kontaktfläche zwischen der Oberfläche des Halbleiterkörpers und der Kunststoffumhüllung weist eine Mikroverzahnung auf.

## Beschreibung

Die Erfindung bezieht sich auf ein Halbleiterbauelement, bei dem an einen Halbleiterkörper mit mindestens einer Kontaktmetallisierung eine Kunststoffumhüllung angrenzt.

Eine solches Halbleiterbauelement ist beispielsweise aus DE 43 27 133 A1 bekannt. Darin ist ein Halbleiterbauelement beschrieben, bei dem eine Lichtemissionsdiode über eine transparente Kunstststoffumhüllung mit einem lichtdetektierenden Halbleiterchip optisch gekoppelt ist. Die transparente Kunststoffumhüllung ist direkt auf die Oberfläche der Halbleiterkörper der Lichtemissionsdiode und des lichtdetektierenden Halbleiterchips aufgebracht.

Die thermischen Ausdehnungskoeffizienten bekannter Umhüllkunststoffe, wie beispielsweise Epoxidharze, und Halbleitermaterialien sind sehr unterschiedlich (αₜₕ(Epoxidharze) = 60 - 200 * 10⁻⁶ K⁻¹, αₜₕ(GaAs) = 6 * 10⁻⁶ K⁻¹, αₜₕ(Si) = 2.5 * 10⁻⁶ K⁻¹). Bei den üblicherweise im Betrieb eines Halbleiterbauelements auftretenden Temperaturschwankungen entstehen daher mechanische Spannungen im Halbleiterbauelement. Im Laufe der Zeit kann es durch diese mechanische Beanspruchung und den damit verbundenen Scherkräften an der Grenzfläche zwischen Halbleiterkörper und Kunststoffumhüllung zu einem Ablösen der Kunststoffumhüllung vom Halbleiterkörper kommen. Ein Ablösen der Kunstoffumhüllung ruft jedoch in den meisten Fällen eine deutliche Beeinträchtigung der Funktionseigenschaften des Halbleiterbauelements hervor. So führt zum Beispiel bei einem Halbleiterbauelement zum Senden und/oder Empfangen von optischen Signalen ein Ablösen der Umhüllung vom Halbleiterkörper zu erheblichen Lichtverlusten.

Es sind daher Maßnahmen erforderlich, die die Haftfestigkeit zwischen Halbleiterkörper und Kunststoffumhüllung erhöhen.

Bekannte Maßnahmen zur Steigerung der Haftfestigkeit zwischen Halbleiterkörper und Kunststoffumhüllung sind:
- Anpassung des thermischen Ausdehnungskoeffizienten des Kunststoffumhüllmaterials,
- Aktivierung der Halbleiteroberfläche, beispielsweise durch Plasmareinigung,
- Zwischenschicht zwischen Halbleiteroberfläche und Kunststoffumhüllung.

Eine geeignete Anpassung des thermischen Ausdehnungskoeffizienten bekannter Kunststoffumhüllmaterialien wie beispielsweise Epoxidharze kann bislang nur durch eine Zugabe von Füllstoffen erzielt werden. Bekannte Füllstoffe sind Metallpulver, Metalloxide, Metallcarbonate und Metallsilikate. Da derartige Füllstoffe neben dem thermischen Ausdehnungskoeffizienten auch die Lichtdurchlässigkeit eines Kunststoffumhüllmaterials beeinträchtigen, ist die Verwendung von Füllstoffen nur in den Fällen möglich, bei denen diese Eigenschaft keine wesentliche Rolle spielt.

Eine Aktivierung der Halbleiteroberfläche oder eine Einbringung einer Zwischenschicht als Haftvermittler zwischen Halbleiteroberfläche und Kunststoffumhüllung ist mit dem Nachteil verbunden, daß dazu zusätzliche, aufwendige Verfahrensschritte notwendig sind.

Der vorliegenden Erfindung liegt daher die Aufgabe zugrunde, ein Halbleiterbauelement zu entwickeln, das eine erhöhte Haftfestigkeit zwischen Halbleiterkörper und Kunststoffumhüllung aufweist, ohne daß eine der oben genannten Maßnahmen erforderlich ist.
Diese Aufgabe wird dadurch gelöst, daß zumindest ein nicht von der Kontaktmetallisierung bedeckter freier Teilbereich der Oberfläche des Halbleiterkörpers eine Aufrauhung aufweist, so daß zwischen dem Halbleiterkörper und der Kunststoffumhüllung eine Mikroverzahnung gebildet ist.

Durch die Mikroverzahnung wird zum einen die Fläche, an der die Oberfläche des Halbleiterkörpers an die Kunststoffumhüllung angrenzt, vergrößert. Zum anderen bewirkt die Mikroverzahnung eine Verteilung der mechanischen Spannungen in das Innere des Halbleiterkörpers und der Umhüllung. Beide Faktoren bewirken eine vorteilhafte Verringerung der Scherkräfte an der Kontaktfläche zwischen Halbleiterkörper und Kunststoffumhüllung.

Die Erfindung wird anhand eines Ausführungsbeispieles in Verbindung mit einer Figur näher erläutert.

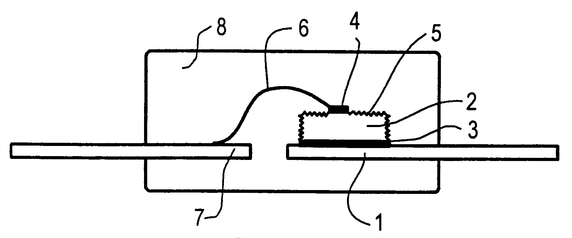

Die Figur zeigt einen Querschnitt durch ein erfindungsgemäßes Halbleiterbauelement, beispielsweise eine Leuchtdiode.

Auf einem Anschlußfinger 1 eines Systemträgers ist ein Halbleiterkörper 2 mit je einer Kontaktmetallisierung 3, 4 an seiner Unterseite und seiner Oberseite angeordnet. Der Halbleiterkörper 2 ist beispielsweise aus AlₓGa₁₋ₓAs, aus InₓGa₁₋ₓAs, aus Si oder aus SiC. Die Kontaktmetallisierungen 3, 4 können aus Aluminium, aus einer Aluminium-Basislegierung oder aus einem anderen unedelen metallischen Werkstoff bestehen. Der Halbleiterkörper 2 weist an den nicht mit einer Kontaktmetallisierung 3, 4 versehenen Oberflächen eine Mikrozahnstruktur 5 auf, die beispielsweise mittels Anätzen hergestellt sein kann. Die Kontaktmetallisierung 3 ist beispielsweise durch ein Pb/Sn-Lot mit dem Anschlußfinger 1 elektrisch leitend verbunden. Die Kontaktmetallisierung 4 ist mittels eines Bonddrahtes 6, beispielsweise ein Golddraht, mit einem Anschlußfinger 7 elektrisch leitend verbunden. Der Halbleiterkörper 2, die Kontaktmetallisierungen 3, 4, der Bonddraht 6 und Teilbereiche der Anschlußfinger 1, 7 sind mit einer transparenten Kunstoffumhüllung 8, beispielsweise aus Epoxidharz, umhüllt.

Durch die Mikrozahnstruktur 5 wird neben der verbesserten Haftfestigkeit der Kunststoffumhüllung 8 auf dem Halbleiterkörper 2 im Falle eines lichtaussendenden und/oder -empfangenden Halbleiterkörpers 2 aufgrund verringerter Totalreflexionsverluste an der Grenze zwischen Halbleiterkörper 2 und Kunststoffumhüllung 8 auch eine verbesserte Lichtein- und/oder -auskoppelung bewirkt.

Ein Verfahren zur Herstellung des oben beschriebenen Halbleiterbauelements weist beispielsweise folgende aufeinanderfolgende Schritte auf:
a) Herstellen des Halbleiterkörpers 2, beispielsweise eine lichtemittierende Diode oder eine Photodiode;
b) Herstellen der Kontaktmetallisierungen 3, 4, beispielsweise durch Aufdampfen;
c) Herstellen der Mikrozahnstruktur 5, beispielsweise durch Anätzen der Oberfläche des Halbleiterkörpers 2;
d) Montieren des Halbleiterkörpers 2 mit den Kontaktmetallisierungen 3, 4 und der Mikrozahnstruktur 5 auf den Anschlußfinger 1 oder auf eine Insel des Systemträgers, beispielsweise durch Kleben oder Löten;
e) Bonden des Anschlußleiters 6 auf die Kontaktmetallisierung 4 und den Anschlußfinger 7;
f) Umhüllen des Halbleiterkörpers 2 mit Mikrozahnstruktur 5, der Kontaktmetallisierungen 3, 4, des Anschlußleiters 6 und von Teilbereichen der Anschlußfinger 1, 7 mit Kunststoff. Das Umhüllen mit Kunststoff erfolgt derart, daß der Kunststoff in die Mikrozahnstruktur 5 eindringt, diese ausfüllt und anschließend aushärtet. Dadurch wird die Mikroverzahnung zwischen Halbleiterkörper 2 und Kunststoffumhüllung 8 ausgebildet. Als Umhüllverfahren kann beispielsweise ein Spritz-Preß-Verfahren angewendet werden.

Ein Verfahren zum Herstellen der Mikrozahnstruktur 5 beispielsweise auf einem Halbleiterkörper 2 aus einer oder mehreren AlₓGa₁₋ₓAs-Schichten (0 ≦ x ≦ 1) und mit Kontaktmetallisierungen 3, 4 aus einem unedelen metallischen Werkstoff, wie beispielsweise Aluminium oder eine Aluminium-Basislegierung, weist beispielsweise folgende aufeinanderfolgende Schritte auf:
a) Vorreinigen der Oberfläche des Halbleiterkörpers 2 zur Herstellung einer hydrophilen Halbleiteroberfläche, eventuell mit einem handelsüblichen Detergenzzusatz;
b) Anätzen der Oberfläche des Halbleiterkörpers 2 beispielsweise mit Salpetersäure (65%). Je nach Aluminiumgehalt x muß für das Anätzen die Temperatur und die Ätzdauer angepaßt werden. Für einen Aluminiumgehalt von 0,30 ≦ x ≦ 0,40 beträgt die Ätzdauer beispielsweise 15 bis 30 Sekunden bei einer Temperatur von 25 ± 5 °C.

Ein weiteres Verfahren zur Herstellung der Mikrozahnstruktur 5 beispielsweise auf einem Halbleiterkörper 2 mit einer oder mehreren AlₓGa₁₋ₓAs-Schichten (0 ≦ x ≦ 0,4) und mit Kontaktmetallisierungen 3,4, die einen unedelen metallischen Werkstoff, wie beispielsweise Aluminium oder eine Aluminium-Basislegierung aufweisen, weist beispielsweise folgende aufeinanderfolgende Schritte auf:
a) Herstellen des Halbleiterkörpers 2;
b) Aufbringen der Kontaktmetallisierungen 3,4;
c) Vorreinigen der Halbleiteroberfläche zur Herstellung einer hydrophilen Halbleiteroberfläche beispielsweise durch Wasserspülen, eventuell mit Detergenzzusatz;
d) Aufrauhätzen mit einer Ätzmischung aus Wasserperoxid (≧ 30%) und Flußsäure (≧ 40%)(1000:6) über eine Dauer von 1 bis 2,5 min.;
e) Nachätzen mit einer verdünnten Mineralsäure, wie z.B. Schwefelsäure (15%), bei 35°C über eine Dauer von 1 bis 2 min.

Je nach Aluminiumgehalt x muß für das Aufrauhätzen die Temperatur und die Ätzdauer angepaßt werden.

## Patentansprüche

1. Halbleiterbauelement, bei dem an einen Halbleiterkörper mit mindestens einer Kontaktmetallisierung eine Kunststoffumhüllung angrenzt, **dadurch gekennzeichnet**, daß zumindest ein nicht von der Kontaktmetallisierung (3) bedeckter freier Teilbereich der Oberfläche des Halbleiterkörpers (2) eine Aufrauhung aufweist, so daß zwischen dem Halbleiterkörper (2) und der Kunststoffumhüllung (8) eine Mikroverzahnung ausgebildet ist.

2. Halbleiterbauelement nach Anspruch 1, **dadurch gekennzeichnet**, daß die Kontaktmetallisierung (3) Aluminium aufweist.

3. Halbleiterbauelement nach Anspruch 1 oder 2, **dadurch gekennzeichnet**, daß die Kontaktmetallisierung (3) aus einer Aluminium-Basislegierung besteht.

4. Verfahren zur Herstellung eines Halbleiterbauelements nach einem der Ansprüche 1 bis 3, **gekennzeichnet durch** die Verfahrensschritte
a) Herstellen des Halbleiterkörpers (2);
b) Herstellen von Kontaktmetallisierungen (3,4);
c) Herstellen einer Mikrozahnstruktur (5) auf der Oberfläche des Halbleiterkörpers (2);
d) Montieren des mit den Kontaktmetallisierungen (3,4) und mit der Mikrozahnstruktur (5) versehenen Halbleiterkörpers (2) auf einen Systemträger;
e) Bonden eines oder mehrerer Anschlußleiter auf die Kontakt metallisierung (3) und auf Anschlußfinger (1,7) des Systemträgers;
f) Umhüllen des Halbleiterkörpers (2), der Kontaktmetallisierungen (3,4), der Anschlußleiter, von Teibereichen der Anschlußfinger (1,7) und mindestens von Teilbereichen des Systemträgers mit Kunststoff, derart, daß der Kunststoff in die Mikrozahnstruktur (5) eindringt, diese ausfüllt und anschließend aushärtet.
